# EUROPEAN PATENT APPLICATION

(11) **EP 2 169 713 A1**
(43) Date of publication of application: **31.03.2010**
(21) Application number: 08791293.7
(22) Date of filing: 17.07.2008
(51) Int. Cl.: H01L 21/66, H01L 33/00, H01S 5/323

(54) **METHOD FOR MANUFACTURING ELECTRONIC DEVICE, METHOD FOR MANUFACTURING EPITAXIAL SUBSTRATE, III NITRIDE SEMICONDUCTOR ELEMENT AND GALLIUM NITRIDE EPITAXIAL SUBSTRATE**

(30) Priority: 17.07.2007 JP 2007186098
(71) Applicant: Sumitomo Electric Industries, Ltd., Chuo-ku Osaka-shi Osaka 540-0041 (JP)
(72) Inventor: SAITOH, Yu, Itami-shi Hyogo 664-0016 (JP)
(74) Representative: Grünecker, Kinkeldey, Stockmair & Schwanhäusser Anwaltssozietät
(86) International application number: PCT/JP2008/062939
(87) International publication number: WO 2009/011394

(57) **Abstract**

In step S103, a gallium nitride semiconductor layer 13 is grown on an n-type GaN substrate 11. In step S 104, a PL spectrum for the gallium nitride based semiconductor layer in a wavelength region including the yellow band of wavelength and the band edge wavelength of the gallium nitride based semiconductor is measured at room temperature. In step S 106, a screened epitaxial substrate E1 is prepared through selection based on comparison of the photoluminescence spectrum intensity in the yellow band of wavelength and the band edge wavelength with a reference value. In step S107, an electrode 15 for an electron device is formed on the screened epitaxial substrate 13.

## Description

### Technical Field

The present invention relates to a method of making an electron device, a method of making an epitaxial substrate for the electron device, a group III nitride semiconductor device, and a gallium nitride epitaxial substrate.

### Background Art

Patent document 1 describes semiconductor light emitting devices such as a light emitting diode having high luminance efficiency and a semiconductor laser having a low threshold. The semiconductor light emitting devices are fabricated with a vapor phase deposition system which enables stable uniform heating at high temperature. In the vapor phase deposition system, its insulating member, which includes at least two segmented insulators, is placed in a gap between conductive parts of a resistance heating element for heating a substrate placed on a susceptor, and the segmented insulators are in contact with the parts in the system, thereby resulting in significantly increased lifetime of the heating element. By use of this system, the concentration of carbon in semiconductor thin films is distributed so as to decease in its growth direction.
[Patent Literature 1] Japanese Unexamined Patent Application Publication No. 9-92883

### Disclosure of Invention

Patent document 1 refers to a light emitting diode and a semiconductor laser. A semiconductor thin film grown by an organometallic vapor phase epitaxy contains a large amount of carbonaceous impurities, which relates to the formation of nonradiative recombination centers.

According to findings by the inventor, a large amount of carbonaceous impurities in an electron device, such as a Schottky diode, which is different from semiconductor light emitting devices causes insufficient ohmic contact in an electrode. For example, a thin film of gallium nitride has a high content of carbonaceous impurities, and then the ohmic contact properties in the electrode becomes unsatisfactory. In a conventional process, after visual observation of the surface of an epitaxial film grown by an organometallic vapor phase epitaxy reactor has been performed for screening out, the screened epitaxial substrates are provided with processes for forming an electrode for an electron device (e.g. a Schottky electrode for a Schottky barrier diode) on the surface thereof.

Electric properties of epitaxial substrates, however, differ from every growth run in an organometallic vapor phase epitaxy reactor. This results from the fluctuation of the concentration of impurities of the epitaxial substrates due to changes of environment in the organometallic vapor phase epitaxy reactor that occur every run for formation of films. The concentrations of the impurities such as carbon in the film formed by the current epitaxial technology are below the minimum quantity that is detectable by secondary-ion mass spectrometry. Accordingly, what is needed is to provide an appropriate index for a high level of purification of an epitaxial film grown in variable growth conditions in the organometallic vapor phase epitaxy reactor.

The present invention has been accomplished in view of such a situation. Accordingly, it is an object of the present invention to provide a method of making an electron device including a group III nitride compound semiconductor by use of an appropriate index for high purity of an epitaxial film grown under variable growth conditions in an organometallic vapor phase epitaxy reactor, and it is another object to provide a method of making an epitaxial substrate for the electron device. Also, it is further object of the present invention to provide a group III nitride compound semiconductor including an epitaxial film which has an appropriate index for achieving the high purity and, it is still another object of the present invention to provide a gallium nitride epitaxial substrate for the electron device.

### Means for Solving Problem

One aspect of the invention provides a method of making an electron device using the group III nitride semiconductor. The method includes the steps of: (a) growing a semiconductor region, composed of at least one gallium nitride based semiconductor layer, on a substrate by organometallic chemical vapor deposition to form an epitaxial substrate; (b) measuring a photoluminescence spectrum of the gallium nitride based semiconductor layer in a wavelength region including a yellow band of wavelength and a band edge wavelength of the gallium nitride based semiconductor layer; (c) creating a ratio of the intensity of the photoluminescence spectrum at the yellow band of wavelength to that at the band edge wavelength thereof; (d) screening the epitaxial substrate by comparing the above ratio of the intensity of the photoluminescence spectrum at the yellow band of wavelength to that at the band edge wavelength with a reference value, to provide a screened epitaxial substrate; and (e) forming an electrode for the electron device on the screened epitaxial substrate.

In this method, the intensity of the photoluminescence spectrum in the wavelength region that contains the yellow wavelength band of the gallium nitride based semiconductor layer and the band edge wavelength provides an effective index for the amount of impurities in the epitaxial layer. Consequently, the use of the relevant screened epitaxial substrate can suppress variations in characteristics of the electron device caused by the impurities in epitaxial films grown in variable growth conditions in the organometallic vapor phase epitaxy reactor. Furthermore, the intensity ratio can provide a judgment indicator for the quality of the epitaxial films grown under variable growth conditions in the organometallic vapor phase epitaxy reactor, without use of the absolute peak intensity of the spectrum at the yellow wavelength band.

In the aspect of the present invention, in the step of measuring the photoluminescence spectrum, it is preferable that the photoluminescence spectrum be measured at room temperature. Since the ambient temperature of the facility in which the electron device is fabricated can be controlled for the quality control of the electron device, the photoluminescence spectrum is also measured at the controlled temperature, e.g. room temperature.

In the aspect of the present invention, the reference value is less than or equal to 0.05 when the reference value is prepared for comparison of the photoluminescence spectrum measured at room temperature. This is a desirable range that the inventor has found.

In the aspect of the present invention, it is preferable that the nitride substrate be made of GaN. A gallium nitride substrate having a low dislocation density is available to grow a high-quality gallium nitride semiconductor layer thereon.

In the aspect of the present invention, it is preferable that the substrate be composed of n-type GaN and that the gallium nitride based semiconductor layer be composed of GaN doped with an n-type dopant. These are suitable for a low-loss electron device.

In the aspect of the present invention, the n-type dopant may be at least one selected from silane, disilane, monomethylsilane, dimethylsilane, trimethylsilane, tetramethylsilane, triethylsilane, tetraethylsilane, monogermane, monomethyl-germanium, tetramethyl-germanium, tetraethyl-germanium, oxygen, carbon monoxide, carbon dioxide, and H₂O.

In the aspect of the present invention, in the step of forming an electrode for the electron device, a Schottky electrode is formed on the selected epitaxial substrate and the electron device includes a Schottky barrier diode. This provides a low-loss Schottky barrier diode.

In the aspect of the present invention, the gallium nitride based semiconductor layer can be the GaN drift layer of the Schottky barrier diode, and the band edge wavelength can be the band edge wavelength of GaN.

This method can prevent unwanted characteristics caused by the impurities in the drift layer of the Schottky barrier diode.

In the aspect of the present invention, the substrate can be composed of a conductive III group nitride. On this group III nitride substrate, an electron device can be fabricated using the group III nitride compound semiconductor. In the aspect of the present invention, the group III nitride can be a conductive gallium nitride. On a conductive gallium nitride substrate of reduced dislocations, an epitaxial layer having an excellent crystalline characteristic and a high-purity can be grown.

In the aspect of the present invention, the electrode forms a Schottky junction with the gallium nitride based semiconductor layer, and the gallium nitride based semiconductor layer includes a gallium nitride layer. This gallium nitride layer can be grown in a temperature of 1050°C or more and can be grown in a temperature of 1200°C or less, and a supplying molar ratio (V/III) of a group V source to a group III source can be 500 or more. In this method, the above condition permits the growth of the nitride based compound semiconductor epitaxial film of an emission ratio, defined as a ratio of the emission peak intensity of the yellow band to the emission intensity at the band edge in the photoluminescence spectrum measured at room temperature, which does not exceed 0.05.

In the aspect of the present invention, the yellow wavelength band ranges from 2.1 eV to 2.5 eV.

Another aspect of the present invention provides a method of making an epitaxial substrate using a group III nitride compound semiconductor. This method includes the steps of: (a) growing a semiconductor region on a substrate by organometallic chemical vapor deposition to form an epitaxial substrate, the semiconductor region including at least one gallium nitride based semiconductor layer; (b) measuring a photoluminescence spectrum for the gallium nitride based semiconductor layers in a wavelength region which includes the yellow band of wavelength and the band edge wavelength of the gallium nitride based semiconductor layer; (c) creating an ratio of an intensity of the photoluminescence spectrum at the yellow band of wavelength to that of the photoluminescence spectrum at the band edge wavelength; and (d) screening the epitaxial substrate based on the comparison of the intensity ratio of the yellow band of wavelength to that at the band edge wavelength in the photoluminescence spectrum with a reference value to provide a screened epitaxial substrate.

In this method, the intensity of the photoluminescence spectrum in the wavelength region including the yellow wavelength band of the gallium nitride based semiconductor layer and the band edge wavelength provides an index effective in estimating the amount of impurities in the epitaxial layer. Consequently, the use of the screened epitaxial substrate can suppress variations in characteristics of the electron device caused by the impurities in the epitaxial film grown in an organometallic vapor phase epitaxy reactor under variable growth conditions.

This epitaxial substrate is suitable for a Schottky barrier diode.

Still another aspect of the present invention provides a group III nitride semiconductor device including a Schottky junction. The group III nitride semiconductor device includes: (a) a conductive group III nitride supporting substrate; (b) a gallium nitride region on a primary surface of the group III nitride supporting substrate, the gallium nitride region having a ratio (I_{Y}/I_{BE}), which does not exceed 0.05, of the emission intensity at the yellow band (I_{Y}) to the emission intensity at the band edge (I_{BE}), and; (c) a Schottky electrode, the Schottky electrode forming a Schottky junction with the gallium nitride region.

In the group III nitride semiconductor device, when the nitride compound semiconductor epitaxial region having the ratio of the yellow band emission intensity to the band edge emission intensity does not exceed 0.05 in the photoluminescence spectrum measured at room temperature, the nitride compound semiconductor epitaxial region has an excellent crystalline quality. This high-quality epitaxial layer for an electron device can suppress the Schottky junction leakage current that is caused by the impurities or inherent defects in the epitaxial region.

Yet another aspect of the present invention provides a group III nitride semiconductor device having a Schottky junction. The group III nitride semiconductor device includes: (a) a conductive group III nitride supporting substrate; (b) a gallium nitride region on a primary surface of the group III nitride supporting substrate, the gallium nitride region having deep level of the energy corresponding to the yellow band of wavelength; and (c) a Schottky electrode, the Schottky electrode forming a Schottky junction with the gallium nitride region. The concentration of the deep level in the gallium nitride region does not exceed a value at which the ratio (I_{Y}/I_{BE}) of the intensity of the photoluminescence spectrum of the deep level at the yellow band (I_{Y}) of wavelength to the intensity (I_{BE}) of the spectrum at the band edge wavelength of the gallium nitride region is 0.05.

In this group III nitride semiconductor device, the concentration of the impurities and inherent defects that are related to the yellow band emission is equal to a level at which the above ratio of the intensity (I_{Y}/I_{BE}) of the photoluminescence spectrum at room temperature does not exceed 0.05. The gallium nitride region has, therefore, an excellent crystalline quality. The electron device having a Schottky junction in contact with the high-quality epitaxial layer can suppress leakage current caused at the Schottky junction by the impurities or the inherent defects in the epitaxial region. Since the concentration of the impurities is very low, the above optical measurement is usable to obtain an index for the concentration by nondestructive determination.

In the group III nitride semiconductor device of the present invention, the deep level can include impurity levels caused by at least one of carbon, hydrogen and oxygen. In this group III nitride semiconductor device, the above impurity levels associated with at least one of carbon, hydrogen and oxygen mainly forms deep levels which contribute to the yellow band emission.

In the group III nitride semiconductor device of the present invention, the group III nitride supporting substrate can be composed of conductive gallium nitride. In this group III nitride semiconductor device, the high-quality crystalline epitaxial film can be formed on the conductive gallium nitride substrate having reduced dislocations.

In the group III nitride semiconductor device, the gallium nitride region can be grown at a molar ratio (V/III) defined as a ratio of a group V source to a group III source, of 500 or more, and the gallium nitride region can be grown at a temperature of 1050°C or more and can be grown at a temperature of 1200°C or less. In this group III nitride semiconductor device, the above growth conditions are applied to the formation of the epitaxial region of the nitride compound semiconductor, and the nitride compound semiconductor has the ratio of the emission intensity at the yellow band to the emission intensity at the band edge in the photoluminescence spectrum measured at room temperature and this ratio does not exceed 0.05.

Yet another aspect of the present invention provides a gallium nitride epitaxial substrate. This gallium nitride epitaxial substrate includes: (a) a conductive group III nitride supporting substrate; and (b) a gallium nitride region provided on a primary surface of the group III nitride supporting substrate. The gallium nitride region has a ratio of an emission intensity of a photoluminescence spectrum in the yellow band of wavelength to the emission intensity of the photoluminescence spectrum at the band edge, and the ratio is more than 0.05. In the gallium nitride epitaxial substrate, when the epitaxial region of the nitride compound semiconductor has the ratio, defined as a ratio of the emission intensity at the yellow band to the emission intensity at the band edge, which does not exceed 0.05 in the photoluminescence spectrum measured at room temperature, this epitaxial region has an excellent crystalline quality. When the high-quality epitaxial layer is applied to an electron device having a Schottky junction, this electron device can suppress the leakage current caused at the Schottky junction by the impurities in the epitaxial region or defects inherent therein.

In the gallium nitride epitaxial substrate of the present invention, the group III nitride supporting substrate can be composed of a conductive gallium nitride. Since a gallium nitride substrate having reduced dislocations is available for the gallium nitride epitaxial substrate, a high-quality crystalline gallium nitride epitaxial film can be grown thereon.

In the gallium nitride epitaxial substrate, the growth temperature of the gallium nitride region is equal to or more than 1050°C and equal to or less than 1200°C. The gallium nitride region can be grown at a molar ratio (V/III), which defmed as a ratio of a group V source to a group III source, of 500 or more. This growth condition can be applied to the formation of the epitaxial film for the gallium nitride region of the photoluminescence intensity ratio that does not exceed 0.05 and this ratio is defined as a ratio of the emission intensity of the yellow band to the emission intensity at the band edge in the photoluminescence spectrum measured at room temperature.

The above-mentioned objects and other objects, features, and advantages of the present invention can be better understood with reference to the attached drawings and the following detailed description of the preferred embodiments of the present invention.

### Effect of the Invention

The present invention provides a method of making an electron device of the group III nitride compound semiconductor using an appropriate index for a high level of purification of an epitaxial film grown under variable growth conditions in the organometallic chemical vapor phase epitaxy reactor, and a method of making the epitaxial substrate for the electron device. In addition, another aspect of the present invention provides the group III nitride semiconductor device including the epitaxial film which has an appropriate index indicating a high level of purification, and the gallium nitride epitaxial substrate for the electron device.

### Brief Description of Drawings

Fig. 1 is a flowchart showing primary steps in a method of making an electron device and in a method of making an epitaxial substrate in accordance with an embodiment of the present invention.
Fig. 2 is a schematic view showing primary steps in a method of making an electron device and a method of making an epitaxial substrate in accordance with an embodiment.
Fig. 3 shows a portion (a) of PL spectra in epitaxial substrates A and B in a wavelength region including the yellow band of wavelength and the band edge wavelength of the gallium nitride based semiconductor, and shows a portion (b) of PL spectra in epitaxial substrates A and B in a wavelength region including the yellow band of wavelength.
Fig. 4 is a graph showing the current-voltage characteristics of Schottky barrier diodes C and D.
Fig. 5 is a graph showing PL spectra of epitaxial substrates A1 and B1 in a wavelength region including the yellow band of wavelength and the band edge wavelength of the gallium nitride based semiconductor.
Fig. 6 is a view illustrating a deep level of the epitaxial substrate for an electron device in accordance with an embodiment.
Fig. 7 is a graph showing the current-voltage characteristics (forward characteristics) of Schottky barrier diodes DA1 and DB1.
Fig. 8 is a graph showing the current-voltage characteristics (reverse characteristics) of Schottky barrier diodes DA1 and DB1.

### Reference Signs List

E1: screened epitaxial substrate;
11: substrate;
13: gallium nitride semiconductor based layer;
15 and 17: electrode for electron device;
19: vertical electron device

### Best Mode for Carrying Out the Invention

With reference to the attached drawings for illustrative purposes, the present invention is easily understood by consideration of the following detailed description. Subsequently, embodiments of a method of making an electron device of the present invention and a method of making an epitaxial substrate are described with reference to the attached drawings. The same reference numerals are assigned to the same parts, if possible.

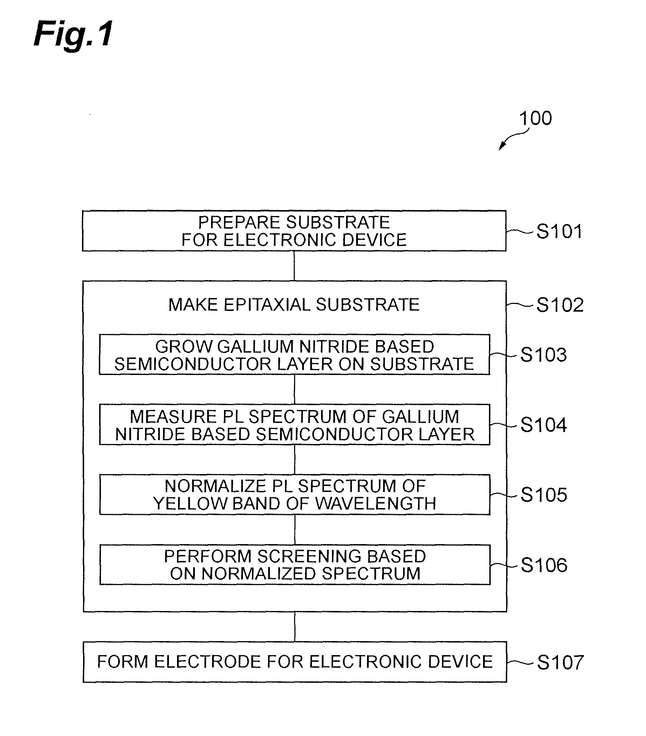

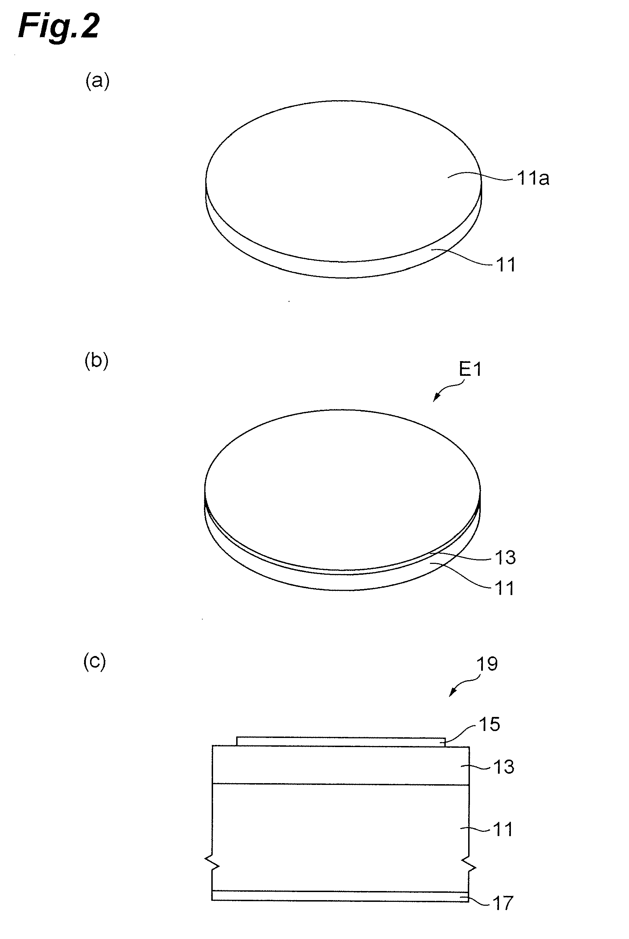

Fig. 1 is a flowchart showing primary steps in a method of making an electron device, in a method of making an epitaxial substrate, and in a method of inspecting the epitaxial substrate in accordance with an embodiment. Fig. 2 is schematic views showing the primary steps in these methods. In S101 of the flowchart 100, a substrate 11 for an electron device is prepared. A silicon substrate, sapphire substrate, silicon carbide substrate and so on can be used as the substrate 11, and further a group III nitride substrate and so on can be used as the substrate 11. Preferably, the group III nitride substrate can be a gallium nitride based semiconductor substrate such as a GaN substrate. In the following description, an n-type GaN substrate (hereinafter indicated by reference numeral 11) is used for the substrate 11. Since a gallium nitride substrate having a low dislocation density is available therefor, a high-quality gallium nitride semiconductor layer can be grown on this GaN substrate. An n-type GaN substrate is suitable for a low-loss vertical electron device (e.g. a Schottky barrier diode, a field-effect transistor). As shown in Part (a) of Fig. 2, in more precise description, epitaxial growth is performed on the primary surface 11a (e.g. c-plane) of the n-type GaN substrate 11 in the subsequent step. This growth is performed by organometallic vapor phase deposition using trimethylgallium (TMG) as a gallium source and ammonia as a nitrogen source.

In step S102, a semiconductor region including one or more gallium nitride based semiconductor layers is grown on a group III nitride substrate by organometallic chemical vapor deposition to form an epitaxial substrate. In step S103, a gallium nitride semiconductor layer 13 is epitaxially grown on the primary surface 11a of the n-type GaN substrate 11. The gallium nitride based semiconductor layer 13 can be, for example, made of GaN, AlGaN, InGaN, InAlGaN and so on. An additional gallium nitride semiconductor layer may be subsequently grown by organometallic chemical vapor deposition, if necessary.

When the group III nitride substrate 11 is made of an n-type GaN, preferably, the gallium nitride based semiconductor layer 13 is composed of GaN doped with an n-type dopant. This is suitable for a low-loss electron device. The above n-type dopant may be at least one selected from silane, disilane, monomethylsilane, dimethylsilane, trimethylsilane, tetramethylsilane, triethylsilane, tetraethylsilane, monogermane, monomethylgermane, tetramethylgermane, tetraethylgermane, oxygen, carbon monoxide, carbon dioxide, and H₂O.

According to a method of inspecting an epitaxial substrate, in step S104, the photoluminescence spectrum (hereinafter indicated by PL spectrum) of the gallium nitride based semiconductor layer 13 is measured in a wavelength region including the yellow wavelength band and the band edge wavelength of the gallium nitride based semiconductor layer. The yellow band of a gallium nitride semiconductor can be a wavelength range (e.g. 2.1 eV to 2.5 eV) corresponding to, for example, 2.3 electron volt (eV, 1 eV corresponding to 1.602 × 10⁻¹⁹ J), where a broad emission peak is observed. The band edge wavelength of the gallium nitride semiconductor corresponds to 3.4 eV, where a sharper peak is observed as compared to the peak in the yellow band.

It is preferable that the PL spectrum be measured at room temperature. Since the ambient temperature of the facility that fabricates electron devices is controlled for their quality control, the PL spectrum can be measured at the controlled temperature, i.e. room temperature, which requires no additional equipment for temperature control during the measurement and causes no variation in temperature. Also, when the PL spectrum measured in the facility, this measurement is not affected by the installation site of the measurement device.

In step S106, an epitaxial substrate E1 is selected based on comparison result of the photoluminescence spectrum intensities at the yellow band of wavelength and the band edge wavelength with the reference value. With reference to Part (b) of Fig. 2, the epitaxial substrate E1 has one or more gallium nitride layers (a single gallium nitride semiconductor layer 13 in this embodiment) on the substrate 11. Through these steps, the epitaxial substrate E 1 is formed.

In this embodiment, in step S105, the ratio of the intensity at the yellow wavelength band to that at the band edge wavelength in the PL spectrum is obtained. This ratio can provide a judgment index for the quality of the epitaxial film grown in an organometallic vapor phase epitaxy reactor under variable deposition conditions, without use of the absolute peak intensity of the spectrum in the yellow band of wavelength. Since the emission in the yellow band is usually weak, the above intensity ratio is less than one. The intensity ratio is compared with a reference value in the step S 106. In the step that measures a PL spectrum, the PL spectrum is measured at room temperature.

In this method, the reference value does not exceed 0.05 on the basis of the value of the photoluminescence spectrum measured at room temperature. This is a suitable range examined by the inventor. Screening based on the reference value is applied to the epitaxial substrate E. In this selection, when an epitaxial substrate does not have a desirable property, this epitaxial substrate is separated for screening out from screened epitaxial substrates that have the desirable property. A screened epitaxial substrate E1 which has the desirable property is screened and is processed in the subsequent fabrication steps.

With reference to Part (c) of Fig. 2, in step S107, an electrode 15 for an electron device is formed on the screened epitaxial substrate E1, and another electrode 17 is formed on the rear surface of the screened epitaxial substrate E 1 to form a substrate product. A large number of vertical electron devices 19 can be fabricated from the substrate product. In the vertical electron device 19, a current from one of the electrodes 15 and 17 flows to the other of the electrodes 15 and 17 via the substrate 11 and the gallium nitride based semiconductor layer 13. If the electron device is, for example, a Schottky barrier diode, then, in the step of forming electrodes for the electron device, a Schottky electrode (corresponding to the electrode 15) is formed on the screened epitaxial substrate E1 while an ohmic electrode (corresponding to the electrode 17) is formed on the rear surface of the screened epitaxial substrate E1. This provides a low-loss Schottky barrier diode.

In this method, the intensity of the PL spectrum in the wavelength region including the yellow wavelength band and the band edge wavelength for the gallium nitride based semiconductor layer 13 provides an effective index indicating the amount of impurities in the epitaxial layer 13. Consequently, the use of the screened epitaxial substrate E1 can suppress variations in properties of the electron device caused by the impurities in the epitaxial layer 13 formed under variable conditions in the phase epitaxy reactor.

Since the ratio of the emission intensity of the yellow band to the emission intensity at the band edge is generated using the PL spectrum measured at room temperature, inevitable batch-by-batch variation because of the process variability among different batches in the epitaxial growth can be reduced. The selected epitaxial substrate, therefore, has controlled variations in electric properties due to the impurities. The electron device made of this epitaxial substrate exhibits reduced leakage current, caused by deep level due to the impurities, in the application of reverse bias voltage, and high reliability.

### Example 1

A gallium nitride film was grown on a substrate by MOCVD. TMG was used as a Ga source. High-purity ammonia was used as a nitrogen source. Highly-purified hydrogen and nitrogen were used as a carrier gas. For example, the purity of the highly-purified ammonia was not less than 99.999%, and purity of each of the highly-purified hydrogen and the highly-purified nitrogen was not less than 99.999995%.

C-plane sapphire substrates were loaded to a MOCVD reactor for cleaning the substrates in hydrogen atmosphere at a temperature of 1050°C under a pressure of 100 Torr (1 Torr corresponding to 133 Pa). After the temperature was decreased to 500°C, a GaN layer of 30 nm was grown in a pressure of 100 Torr and a condition of V/III=1600. Then, after the temperature was increased to 1070°C, a GaN layer of 3 µm thick was grown to form two templates for the epitaxial deposition of GaN in a pressure of 200 Torr and a condition of V/III=500.

Then, one of these GaN templates and a c-plane n-type GaN wafer having a size of 2 inch were loaded in the MOCVD reactor. After the temperature was increased to 1050°C in a pressure of 200 Torr and a condition of V/III=1250, a GaN drift layer of 2 µm thick was grown to form an epitaxial substrate A by use of the GaN template and an epitaxial substrate C by use of the n-type GaN wafer.

Aside from these, the other GaN template and another c-plane n-type GaN wafer having a size of 2 inch were loaded in the MOCVD reactor, and film formation is performed thereon in the above-described deposition conditions to form an epitaxial substrate B and an epitaxial substrate D by use of the GaN template and the n-type GaN wafer, respectively.

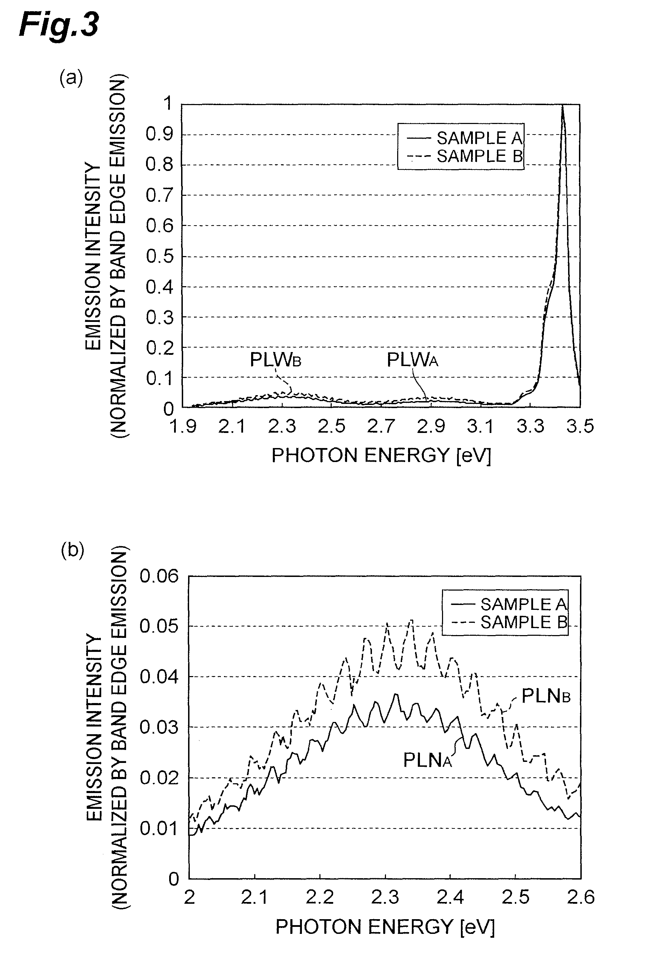

The PL spectra of the epitaxial surfaces of the epitaxial substrates A and B, for which GaN substrates were not used, were measured. Part (a) of Fig. 3 is a graph showing PL spectra of the epitaxial substrates A and B. The spectra were measured in a wavelength region including the yellow wavelength band and the band edge wavelength of the gallium nitride based semiconductor. In the PL spectra PLW_{A} and PLW_{B} for these epitaxial substrates A and B, the yellow band is a wavelength range corresponding to, for example, about 2.3 eV, where broad emission peaks were observed. The band edge wavelength of gallium nitride is the wavelength corresponding to 3.4 eV, where a sharper peak was observed as compared to the peaks in the yellow band. With reference to Part (a) of Fig. 3, each PL spectrum is normalized by the peak value at the band edge wavelength. Part (b) of Fig. 3 is a graph showing partial PL spectra of the epitaxial substrates A and B in a wavelength region including the yellow band of wavelength, respectively.

In the PL spectra PLN_{A} and PLN_{B} for the epitaxial substrates A and B, their ratios of the emission intensity of the yellow band to the emission intensity at the band edge, i.e. the yellow band emission intensity/the band edge emission intensity, are 0.035 for the epitaxial substrate A and 0.05 for the epitaxial substrate B.

In comparison of the PL spectra PLN_{A} and PLN_{B}, the yellow band intensity of the epitaxial substrate B is higher than that of the epitaxial substrate A. This indicates that the GaN drift layer of the epitaxial substrate A contains larger amounts of impurities. According to a report, the impurities such as carbon (C), hydrogen (H), and oxygen (O) may contribute to the yellow band emission and these kinds of atoms form complex defects by themselves or by coupling them with Ga holes in the crystal, so that the deep levels that contributes to the yellow band emission are formed. These deep levels act as electron traps, and function as carrier suppliers in the depletion layer in a reverse bias mode to increase the leakage current. This example indicated that the quality of the epitaxial substrate was related to the yellow band emission intensity and the band edge emission intensity.

### Example 2

Schottky barrier diodes were made from the epitaxial substrates C and D prepared on the GaN substrates in Example 1. An Au-Schottky electrode was formed on the surface of the epitaxial film, while a Ti/AI/Ti/Au ohmic electrode was formed on the rear surface of the GaN substrate, so that the Schottky barrier diodes C and D were produced. These electrodes were formed on the epitaxial substrates C and D at the same time.

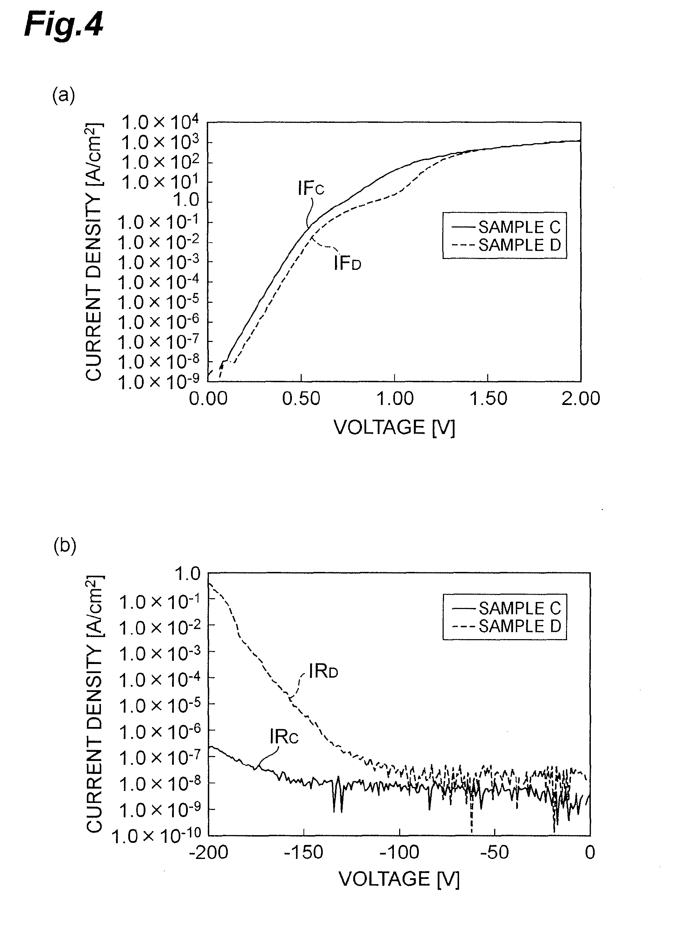

Part (a) of Fig. 4 is a graph showing the current-voltage characteristics (forward direction) of the Schottky barrier diodes C and D. Part (b) of Fig. 4 is a graph showing the current-voltage characteristics (reverse direction) of the Schottky barrier diodes C and D.
The breakdown voltage and on-resistance of the Schottky barrier diodes C and D are shown below.
Device: Reverse-biased breakdown voltage; Forward-biased on-resistance.
Schottky barrier diode C: Not less than 200 V; 1.17 mΩcm²
Schottky barrier diode D: 175 V; 0.78 mΩcm²

The on-resistances in the forward direction are values at 1.26 V and 1.32 V (voltage value) of the current-voltage characteristic curves (forward direction) IF_{C} and IF_{D}, respectively. The current-voltage characteristic curves (reverse direction) IRC and IRD indicate that the reverse bias leakage of the Schottky barrier diode D is larger than that of the Schottky barrier diode C. As described above, the epitaxial substrate D of the Schottky barrier diode D is fabricated in the same batch as the epitaxial substrate B, and thus has a larger yellow band emission intensity. The photoluminescence spectra in Example 1, therefore, shows that such a difference in characteristics results from the higher purity of the drift layer of the epitaxial substrate C as compared to the purity of the drift layer of the epitaxial substrate. It means that a reduction in the deep level formed by impurities which contribute to the yellow band emission can suppress the reverse bias leakage current associated with by this kind of levels.

In the fabrication of GaN Schottky barrier diodes, run-by-run variation in environment in the organometallic vapor phase epitaxy reactor causes fluctuation of the concentration of impurities contained in the epitaxial film. This leads to variable electric properties of the epitaxial film. Since the concentrations of the impurities in the epitaxial film are below a detection limit in secondary-ion mass spectrometry (SIMS), no indicator has been found to monitor the variable deposition conditions in the organometallic vapor phase epitaxy reactor. Meanwhile, improving characteristics of GaN Schottky barrier diodes by enhancing the quality of the epitaxial film have been expected.

As described above, the ratio of the intensity of the emission at the band edge to the intensity of the yellow band emission, which is obtained through the measurement of the PL spectrum including the yellow band emission and the band edge emission, is evaluated after the epitaxial growth of the GaN semiconductor layer, e.g. a drift layer, and before the formation of electrodes, thereby leading to homogenization and improved quality of epitaxial substrates for electron devices. Also, a high voltage vertical electron device (e.g. a Schottky barrier diode) having a satisfactory characteristics can be fabricated. Furthermore, the variations in the characteristics of the products due to the property of the epitaxial substrate can be suppressed.

### Example 3

As described below, the characteristic of a device was evaluated from a photoluminescence spectrum of an epitaxial film. This evaluation suggests the relation between the PL spectrum of the GaN epitaxial layer and the characteristic of the Schottky device. N-type self-standing GaN wafers were used as substrates, and these GaN wafers have a threading dislocation density of not higher than 1×10⁶ cm⁻². Two n-type self-standing GaN wafers of the same quality were selected for the following experiment. The n-type dopant of the self-standing GaN wafers was oxygen.

For the deposition of a gallium nitride film on one of the GaN wafers by MOCVD, TMG and high-purity ammonia were used as a Ga source and a nitrogen source, respectively. Purified hydrogen and nitrogen were used for a carrier gas. The high-purity ammonia has a purity of not less than 99.999%, and the highly-purified hydrogen and the highly-purified nitrogen have a purity of not less than 99.999995%.

The surface of the substrate (c-plane GaN) was processed for cleaning in a reactor at a temperature of 1050°C under a pressure of 100 Torr in an atmosphere containing hydrogen and ammonia. Subsequently, a GaN drift layer was grown at a V/III of 1250 at a substrate temperature of 1050°C under a pressure of 200 Torr in the reactor. The thickness of the GaN drift layer was 2 µm, and Si concentration of the GaN drift layer was 1×10¹⁶ cm⁻³. Through these steps, an epitaxial substrate A 1 was prepared.

Also, the other n-type free-standing GaN wafer was processed for cleaning in a similar way. Subsequently, a GaN drift layer was grown in the reactor at a V/III of 1250 at a substrate temperature of 1000°C under a pressure of 200 Torr. The thickness of the GaN drift layer was 2 µm, and Si concentration of the GaN drift layer was 1×10¹⁶ cm⁻³. Through these steps, an epitaxial substrate B 1 was prepared.

Regarding the temperature for the formation of films, the growth temperature of the gallium nitride layer may be 1050°C or higher. This can suppress contamination by carbonaceous impurities from sources of the raw material. Also, the growth temperature of the gallium nitride layer may be 1200°C or less. This can suppress the nitrogen dissociation during the growth of the film. The thickness of the GaN drift layer can be in the range from 1 µm to 20 µm. The concentration of the dopant in the GaN drift layer can be in the range from 1×10¹⁵ cm⁻³ to 2×10¹⁶ cm⁻³.

Regarding the molar ratio V/III, the molar ratio (V/III) may be 500 or more. This can prevent the formation of defects related to nitrogen vacancies and the contamination of carbonaceous impurities. Also, the molar ratio (V/III) may be 5000 or less. This can prevent the introduction of defects associated with gallium vacancies.

After the epitaxial substrates A1 and B1 were unloaded from the phase epitaxy reactor, the PL spectra of the epitaxial substrate A1 and B1 were obtained from the surfaces of the epitaxial films of the epitaxial substrates A1 and B1 for the measurement of the PL spectra.

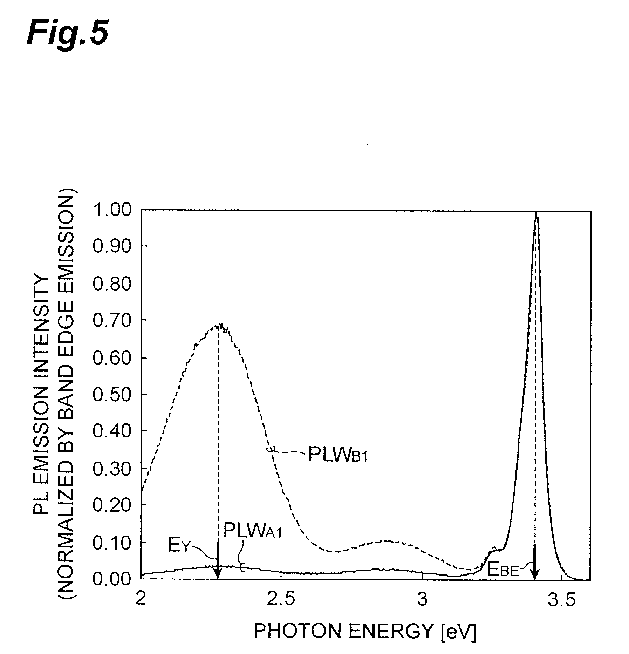

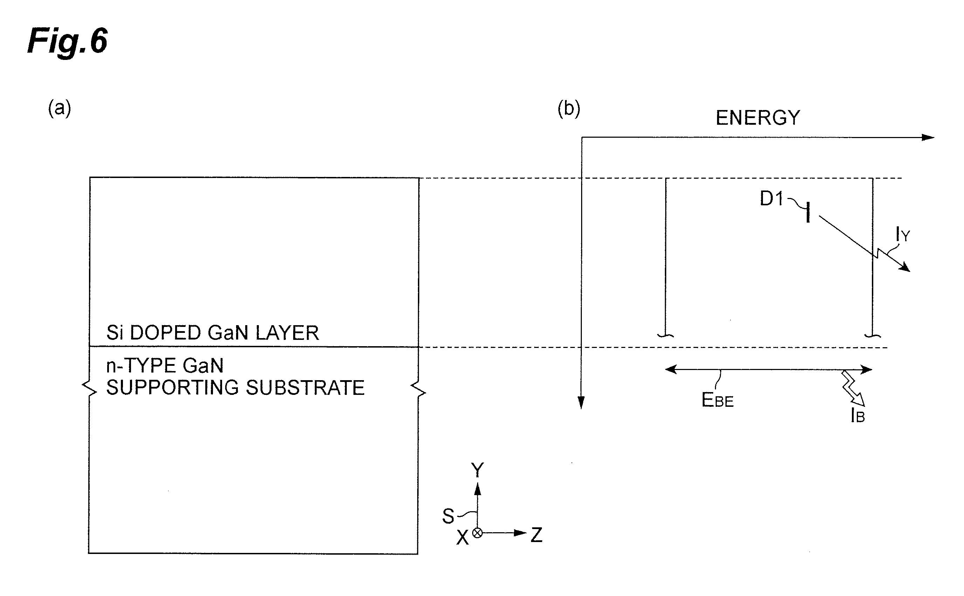

Fig. 5 is a graph showing the PL spectra of the epitaxial substrates A1 and B1. Fig. 6 shows the structure of the epitaxial substrates A1 and B1. These PL spectra were measured in a wavelength range including the yellow band of wavelength and the wavelength of the band edge of the gallium nitride based semiconductor layer. In the PL spectra PLW_{A1} and PLW_{B1} of these epitaxial substrates A1 and B1, the yellow band is a wavelength range, for example, corresponding to the wavelength of the peak energy E_{Y} (e.g. 2.3 eV), and a broad emission peak was observed in this wavelength range, similarly to the above examples. With reference to Fig. 6, the broad peak of the yellow band represents emission I_{Y} by deep level D1 in the epitaxial film. Meanwhile, the band edge emission I_{B} is inherent in the GaN drift layer. The band edge wavelength of gallium nitride is the wavelength corresponding to the band gap E_{BE} (3.4 eV) of gallium nitride, and the sharper peak is observed as compared to the peak of the yellow band. With reference to Fig. 5, each PL spectrum is normalized by the peak value at the band edge wavelength. A He-Cd laser having a wavelength of 325 nm was used for the measurement of the PL spectrum. The following condition of the excitation light is used:
Diameter of the spot: 0.5mm
Power: 1.2 mW (0.6 W/cm²)

In the PL spectra PLW_{A1} and PLW_{B1} of the epitaxial substrates A1 and B1, the ratios of the emission intensity of the yellow band to the emission intensity at the band edge are as follows:
Yellow band emission intensity/Band edge emission intensity (I_{Y}/I_{B})
0.05 for the epitaxial substrate A1;
0.7 for the epitaxial substrate B1.
The ratio (I_{Y}/I_{B}) is obtained as follows: For example, the intensity (I_{B}) is the peak value of the band edge emission intensity, and the intensity (I_{Y}) is the peak value of the PL spectrum of the yellow band.

The comparison of the epitaxial substrates A1 and B1 with each other shows that the yellow band intensity of the epitaxial substrate B1 is higher than that of the epitaxial substrate Al1 This indicates that the GaN drift layer of the epitaxial substrate B1 contains more impurities. The impurities related to the yellow band emission encompass carbon (C), hydrogen (H), and oxygen (O). The evaluation of these elements by SIMS showed background levels of signals. According to an estimate by the inventor, the concentration of carbon (C) is less than 1×10¹⁶ cm⁻³ the concentration of hydrogen (H) is less than 7×10¹⁶ cm⁻³, and the concentration of oxygen (O) is less than 2×10¹⁶ cm⁻³. There is a report suggesting the possibility that the impurities including the above elements form complex defects by themselves or by coupling them with Ga vacancies or N vacancies in the crystal, so that deep levels related to the yellow band emission are formed. It is estimated that the concentration of the deep levels which are luminescent is less than 1×10¹⁶ cm⁻³. These deep levels may act as electron traps and scattering centers to the majority carrier, so that the on-resistance in the forward-bias characteristics of the electron device is increased. Meanwhile, these deep levels function as carrier sources in a depletion layer formed in a reverse bias application, so that the leakage current may be increased.

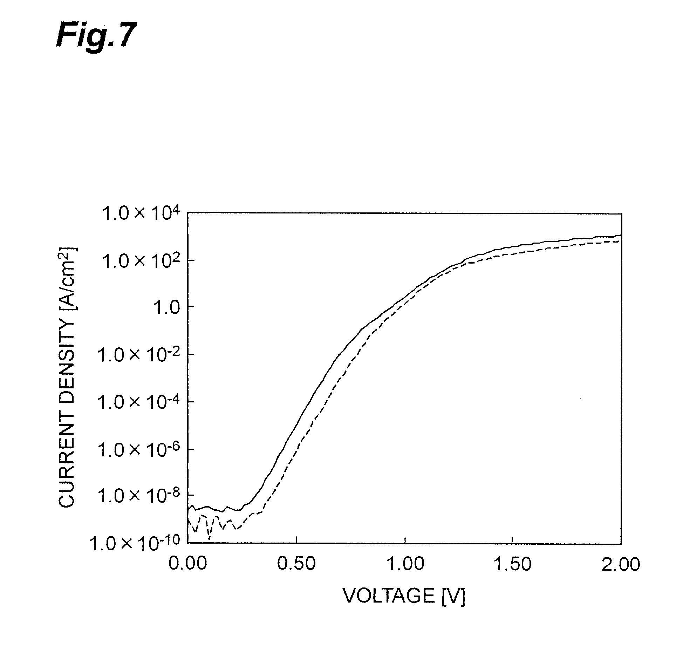

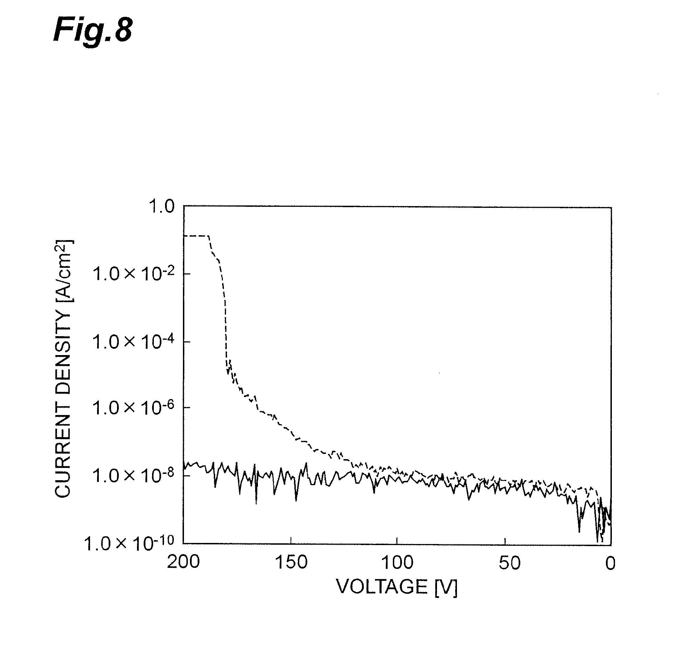

Schottky barrier diodes were made from the epitaxial substrates A1 and B1. An electrode was formed on each of the epitaxial substrates A1 and B 1 in the same step. A Schottky electrode (e.g. Au electrode) was formed on the surface of each epitaxial film, and an ohmic electrode (e.g. Ti/Al/Ti/Au) was formed on the rear surface of each GaN wafer. The current-voltage characteristics of these Schottky barrier diodes DA1 and DB1 were measured. Fig. 7 is a graph showing the current-voltage characteristics in the application of forward bias to the Schottky barrier diodes. The on-resistance of the diodes was estimated from the current-voltage characteristics in the forward direction. Fig. 8 is a graph showing the current-voltage characteristics in the application of reverse bias to the Schottky barrier diodes. The breakdown voltage in the reverse direction in the diode was estimated using the current-voltage characteristics in the reverse direction.
Diode: Reverse-biased breakdown voltage; Forward-biased on-resistance.

| | |
|---|---|
| Diode DA1: Not less than 200 V; | 0.77 mΩcm² |
| Diode DB 1: 181 V; | 1.46 mΩcm² |

As described above, the epitaxial film for the drift layer is grown to form the epitaxial substrate in this embodiment. Prior to the formation of an electrode on the epitaxial substrate, the PL spectrum of the epitaxial substrate is measured to determine the ratio of the intensity of the band edge emission to the intensity of the yellow band emission. When this intensity ratio is smaller than the reference value, the electron device made by forming a Schottky electrode on the epitaxial substrate (a semiconductor device with a Schottky junction) exhibits excellent electric properties. This embodiment can be applied to semiconductor devices, having a Schottky junction such as a Schottky gate transistor, in addition to a Schotky barrier diode.

Although the principle of the present invention has been described and illustrated in the preferred embodiments, it is understood that the invention may be modified in the arrangement and details without departing from the principle by those skilled in the art. Having described, for example, a vertical electron device such as Schottky barrier diode, the invention is not limited to the examples disclosed in the embodiments. Although a GaN drift layer has been illustrated in the embodiments, the invention may be applied to the evaluation of the active layer of a nitride semiconductor field-effect transistor. We therefore claim all modifications and variations coming within the spirit and scope of the following claims.

### Industrial Applicability

Power devices are affected by an epitaxial film(s) formed thereon. An index for the quality of the epitaxial film for the power device had been required. The embodiments have shown that the PL spectrum of the epitaxial film for the power device is related to the Schottky characteristics.

## Claims

1. A method of making an electron device using a group III nitride semiconductor, the method comprising the steps of:
growing a semiconductor region on a substrate by organometallic chemical vapor deposition to form an epitaxial substrate, the semiconductor region comprising at least one gallium nitride based semiconductor layer;
measuring a photoluminescence spectrum of the gallium nitride based semiconductor layer in a wavelength region, the wavelength region including a yellow band of wavelength and a band edge wavelength of the gallium nitride based semiconductor layer;
creating a ratio of an intensity of the photoluminescence spectrum at the yellow band of wavelength to that at a band edge wavelength;
screening the epitaxial substrate based on comparison of the ratio of the intensity of the photoluminescence spectrum at the yellow band of wavelength to that at the band edge wavelength with a reference value to provide a screened epitaxial substrate; and
forming an electrode for the electron device on the screened epitaxial substrate.

2. The method according to claim 1, wherein in the step of measuring the photoluminescence spectrum, the photoluminescence spectrum is measured at room temperature, and the reference value is compared with the ratio.

3. The method according to claim 1 or claim 2, wherein the reference value is 0.05 in terms of a value of the photoluminescence spectrum measured at room temperature.

4. The method according to any one of claims 1 to 3, wherein the substrate comprises GaN.

5. The method according to any one of claims 1 to 3, wherein the substrate comprises n-type GaN, and
the gallium nitride based semiconductor layer comprises GaN doped with an n-type dopant.

6. The method according to claim 5, wherein the n-type dopant includes at least one of silane, disilane, monomethylsilane, dimethylsilane, trimethylsilane, tetramethylsilane, triethylsilane, tetraethylsilane, monogermane, monomethylgermane, tetramethylgermane, tetraethylgermane, oxygen, carbon monoxide, carbon dioxide, and H₂O.

7. The method according to any one of claims 1 to 6, wherein in the step of forming an electrode for the electron device, a Schottky electrode is formed on the screened epitaxial substrate, and
the electron device is a Schottky barrier diode.

8. The method according to claim 7, wherein the gallium nitride based semiconductor layer is a GaN drift layer for the Schottky barrier diode, and
the band edge wavelength is a band edge wavelength of GaN.

9. The method according to any one of claims 1 to 8, wherein the substrate comprises a conductive group III nitride.

10. The method according to any one of claims 1 to 9, wherein the electrode forms a Schottky junction with the gallium nitride based semiconductor layer,
the gallium nitride based semiconductor layer includes a gallium nitride layer,
a growth temperature of the gallium nitride layer ranges from 1050°C to 1200°C, and
a molar ratio (V/III) of a group V source to a group III source in growth of the gallium nitride layer is 500 or more.

11. The method according to any one of claims 1 to 10, wherein the yellow band of wavelength ranges from 2.1 eV to 2.5 eV.

12. A method of making an epitaxial substrate for an electron device using a group III nitride compound semiconductor, the method comprising the steps of:
growing a semiconductor region on a substrate by organometallic chemical vapor deposition to form an epitaxial substrate, the semiconductor region comprising at least one gallium nitride based semiconductor layer;
measuring a photoluminescence spectrum of the gallium nitride based semiconductor layer in a wavelength region, the wavelength region including a yellow band of wavelength and a band edge wavelength of the gallium nitride based semiconductor layer;
creating a ratio of an intensity of the photoluminescence spectrum at the yellow band of wavelength to that at the band edge wavelength; and
screening the epitaxial substrate based on comparison of the ratio of the intensity of the photoluminescence spectrum at the yellow band of wavelength to that at the band edge wavelength with a reference value to provide a screened epitaxial substrate.

13. A group III nitride semiconductor device having a Schottky junction, comprising:
a conductive group III nitride supporting substrate;
a gallium nitride region provided on a primary surface of the group III nitride supporting substrate, the gallium nitride region having a ratio (I_{Y}/I_{BE}) of an emission intensity of a photoluminescence spectrum at a yellow band (I_{Y}) to that at a band edge (I_{BE}), and the ratio (I_{Y}/I_{BE}) being not more than 0.05; and
a Schottky electrode having a Schottky junction with the gallium nitride region.

14. A group III nitride semiconductor device having a Schottky junction, comprising:
a conductive group III nitride supporting substrate;
a gallium nitride region on a primary surface of the group III nitride supporting substrate, the gallium nitride region having deep levels, energy of the deep levels corresponding to a yellow band of wavelength; and
a Schottky electrode having a Schottky junction with the gallium nitride region;
a concentration of the deep levels in the gallium nitride region being equal to or less than a value, and a ratio (I_{Y}/I_{BE}) of an intensity of a photoluminescence spectrum of a deep level in the yellow band of wavelength I_{Y} to that at a band edge wavelength of the gallium nitride region I_{BE} being 0.05 at the value.

15. The group III nitride semiconductor device according to claim 14, wherein the deep levels are associated with at least one of the following impurities: carbon; hydrogen; and oxygen.

16. The group III nitride semiconductor device according to any one of claim 13 to 15, wherein the group III nitride supporting substrate comprises conductive gallium nitride.

17. The group III nitride semiconductor device according to any one of claims 13 to 16, wherein
a growth temperature of the gallium nitride region is equal to 1050°C or more, and the growth temperature of the gallium nitride region is equal to 1200°C or less, and
the gallium nitride region is grown in a molar ratio (V/III) of 500 or more, and the molar ratio is defmed as a ratio of a group V source to a group III source.

18. A gallium nitride epitaxial substrate comprising:
a conductive group III nitride supporting substrate; and
a gallium nitride region on a primary surface of the group III nitride supporting substrate, the gallium nitride region having a ratio of an emission intensity of a photoluminescence spectrum at a yellow band of wavelength to an emission intensity of the photoluminescence spectrum at its band edge, and the ratio being equal to 0.05 or less.

19. The gallium nitride epitaxial substrate according to claim 18, wherein the supporting substrate comprises conductive gallium nitride.

20. The gallium nitride epitaxial substrate according to claim 18 or claim 19, wherein
a growth temperature of the gallium nitride region is equal to 1050°C or more, and the growth temperature of the gallium nitride region is equal to 1200°C or less, and
the gallium nitride region is grown at a molar ratio (V/III) of 500 or more, and the molar ratio (V/III) is defined as a ratio of a group V source to a group III source.
